# EUROPEAN PATENT SPECIFICATION

(11) **EP 0 645 001 B1**
(45) Date of publication and mention of the grant of the patent: **15.01.1997**
(21) Application number: 92914047.3
(22) Date of filing: 11.06.1992
(51) Int. Cl.: G01J 5/20

(54) **USE OF VANADIUM OXIDE IN MICROBOLOMETER SENSORS**
VERWENDUNG VON VANADIUM OXYD IN MIKROBOLOMETER SENSOREN
UTILISATION D'OXYDE DE VANADIUM DANS DES DETECTEURS DE MICROBOLOMETRE

(43) Date of publication of application: 29.03.1995
(73) Proprietor: HONEYWELL INC., Minneapolis Minnesota 55408 (US)
(72) Inventor: WOOD, R., Andrew, Bloomington, MN 55420 (US)
(74) Representative: Fox-Male, Nicholas Vincent Humbert
(86) International application number: US9204893
(87) International publication number: WO9325877

(56) References cited:
- DE-A- 2 253 214
- US-A- 3 484 611
- US-A- 3 619 614

## Description

The U.S. Government has certain rights in this invention pursuant to the terms of a contract DAAL01-85-C-0153.

### BACKGROUND AND SUMMARY OF THE INVENTION

This invention is directed to the field of microbolometer infrared radiation sensors. Particularly described herein is the use of a new detector material (ABₓ) in the microbolometer sensor.

A monolithic integrated focal plane sensitive to both mm-waves (typically 94GHz) and (typically 3-5x10⁻⁶m and 8-12x10⁻⁶m) IR radiation is constructed on a silicon wafer by selective anisotropic etching to fabricate microbolometer radiation sensors in a linear or two-dimensional array. Sensors intended for IR detection are coated with an IR absorbing material. Those intended for mm-wave sensing are connected to metal film antennas deposited on the surface of the silicon wafer. In this structure there is combined known silicon IC processing techniques with a rugged high-g-load-tolerant structure that permits the thermal conduction losses to approach the radiative losses of the element. Of particular importance is the combining and interspersing of millimeter wave sensors with high performance infrared sensors and electronics on the same silicon chip, and fabricating in the same processing steps.

The fabrication of novel three-dimensional microelectronic devices in a semiconductor crystal, typically silicon has been accomplished by fabricating the device through many techniques including isotropic and anisotropic etching. These techniques utilize the cystalline structure of a single crystal semiconductor. An example is the Johnson et al. US patent 4,472,239, "Method of Making Semiconductor Device", assigned to the same assignee as the present invention. The referenced patent shows that the technique is known to manufacture micromechanical devices by etching into single crystal silicon. The citation of this patent is provided merely as background and is not deemed as prior art to the specific invention claimed in this application.

In the prior art, such as US Patent 3,801,949, there has been taught an infrared sensitive solid-state imaging device which is small in size and which has a two-dimensional array of IR detector elements in an integrated microcircuit. The detector array is fabricated on a single crystal silicon substrate coated with a thin layer of electrical insulating material, such as silicon dioxide or silicon nitride. Etched openings are made in the silicon beneath the insulating layer wherever a sensing element is desired for the purpose of thermally isolating the sensing elements from their surroundings.

The present invention provides an infrared radiation detector comprising a monolithic integrated microbolometer linear array radiation detector for thermal imaging and thermal detection, characterised by: a semiconductor body having a plurality of depressions formed in a linear pattern on a first surface of the semiconductor body; a plurality of thin film dielectric members each attached to the first surface, at least at one location, and positioned to suspend each dielectric member as a thermally isolated structure over a corresponding depression; a thin film layer of vanadium oxide embedded in each said dielectric member at a location over the corresponding depression, said thin film layer having a high temperature coefficient of resistance; and a contact for each thin film layer of vanadium oxide, adapted to couple to a measuring circuit.

### BRIEF DESCRIPTION OF THE DRAWINGS

Figure 1 shows a pertinent section of the electromagnetic spectrum;
Figure 2a is one embodiment of a microsensor linear array;
Figure 2b discloses in two-dimensional geometry one embodiment of an integrated dual-mode IR sensors and mm-wave sensors;
Figure 3 shows a cross section of a microsensor structure;
Figure 4 shows the front surface detail of full-wave dipole antenna integrated IR/mm-wave array;
Figures 5a and 5b show detail of high thermal isolation microsensor;
Figure 6 shows the overall scanned array functional diagram;
Figures 7 and 8 show the dual mode sensor design using bow-tie microantenna design.
Figure 9 shows one embodiment of a dual-mode system illustrated schematically in Figure 6.

### DESCRIPTION

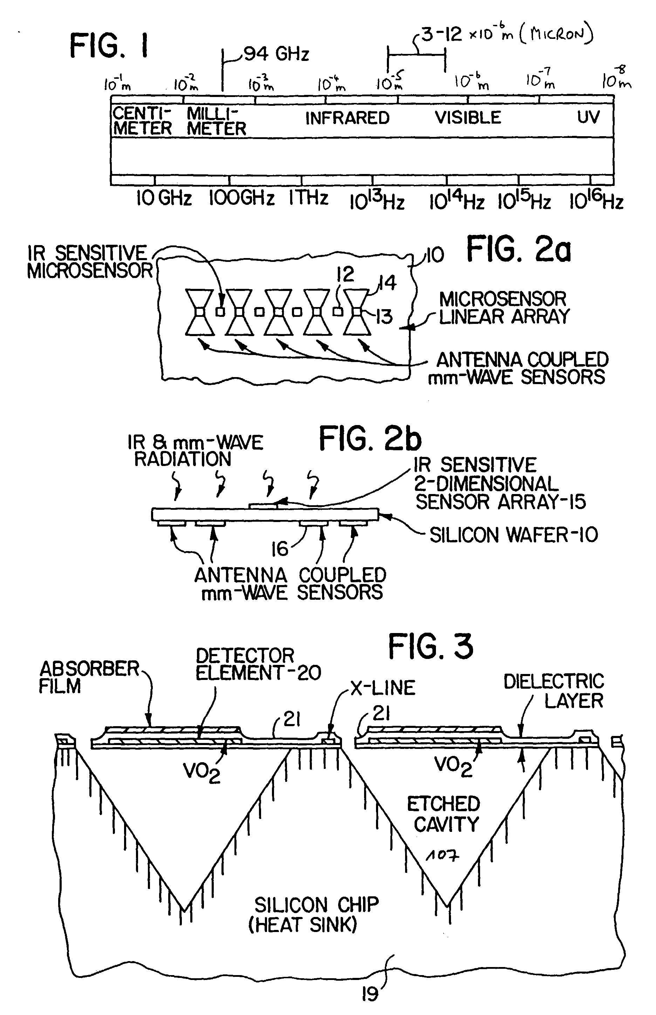

Referring now to Figure 2a there is shown a linear geometry version of a monolithic integrated dual mode IR/mm-wave microsensor linear array. Two-dimensional arrays maybe obtained by constructing several adjacent linear arrays. A focal plane sensitive to both IR radiation (3-5 and/or 8-12 micron) and mm-waves is constructed on a semiconductor substrate wafer 10, such as monocrystalline silicon. The microsensors 12 intended for IR sensing are coated with an IR absorbing material such as a thin metal film. The microsensors 13 intended for mm-wave sensing are connected to metal film antennas 14 deposited on the surface of the silicon wafer. A two-dimensional geometry version is shown in Figure 2b in which IR sensitive microsensor arrays 15 are formed on one surface of the silicon wafer 10 and antennas 16 are formed on the other surface of the wafer. This embodiment will be described later.

In Figure 3 there is shown a cross section of a microsensor structure showing the thermal isolation configuration as taught in US patent 4,472,239, above referenced. The microsensor imaging array is on a silicon chip 19, based upon anisotropic silicon etching in which a small mass, thin film radiation detector 20 is fabricated into a thermally isolated dielectric cantilever structure 21 on the surface of the silicon chip. The small mass and thermal isolation provide arrays with excellent detector sensitivity and response time. The millimeter-wave array uses planar dipole or bow-tie type antennas to couple the mm-wave radiation to the thermally integrating microsensors.

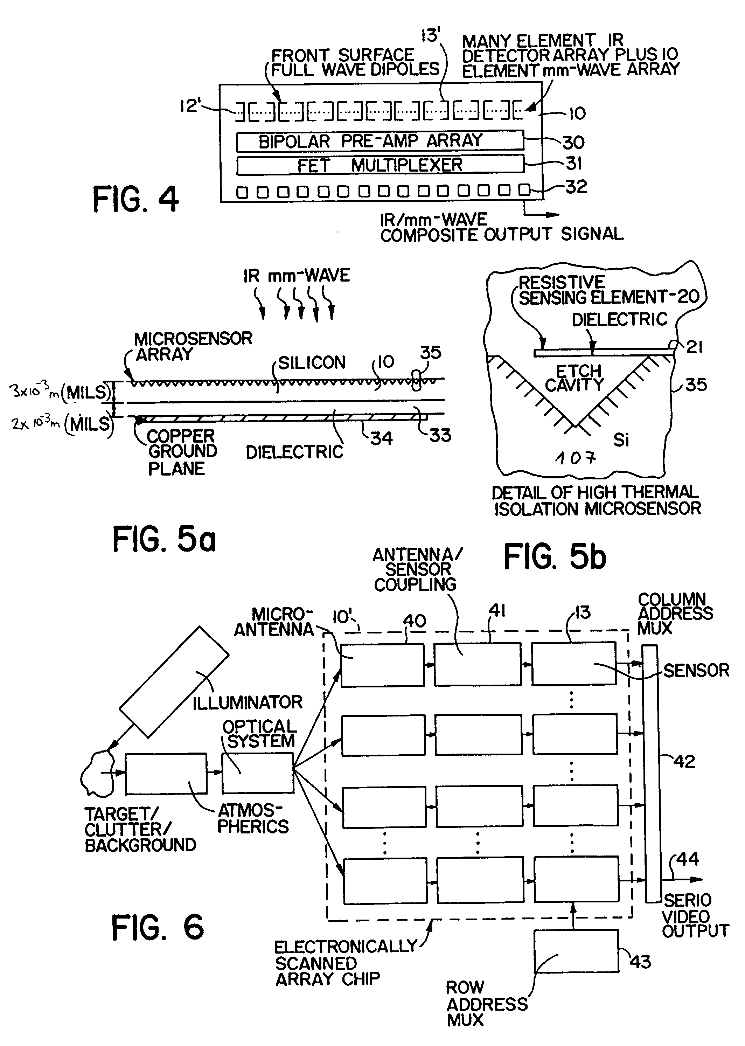

In Figure 4 there is shown a detail of the front surface of a full-wave dipole antenna type integrated infrared/millimeter wave sensor electronically scanned linear array. Interspersed with the multielement (ex. =300) IR detector elements 12' are a plurality (ex. = 10) of antenna coupled mm-wave elements 13'. Also shown in block form is a bipolar pre-amp array 30 and an fet multiplexer 31. An IR/mm-wave output signal is detected at 32. A partial cross section of Figure 4 cut through the detector array is shown in Figure 5a. The silicon wafer 10 also includes a dielectric layer 33 and a copper ground plane 34. A detail of one of the high thermal isolation microsensors 35 is shown in the balloon of Figure 5b in which a resistor sensor 20 carrying dielectric cantilever 21 is thermally isolated by the etch cavity in the silicon.

A structure which is required to couple efficiently to a mm-wave radiation field must necessarily have dimensions of the order of about the wavelength, e.g. 3x10⁻³m (3 millimeters) at 94GHz. In the case of an uncooled sensor, a sensitive area this large would lead to degraded responsivity or response speed due to the increased thermal mass of the sensor. We therefore require dimension of a few mils, and must therefore couple the sensor to the radiation field via an antenna structure with dimensions of the order of the wavelength. Since microsensor arrays can be conveniently fabricated on silicon substrates by photolithographic processes, we desire the antenna and any coupling waveguides to be planar in design.

The mm-wave array portion, such as shown in Figures 2a and 4, is further shown in Figure 6 and consists of a silicon substrate 10', upon which we use photolithography to fabricate an array of planar microantennas 40, coupling waveguides 41 and microsensors 13, with electrical leadouts to an electronic readout circuit as shown in Figure 6. MM-wave radiation is collected by the microantennas 40, and coupled 41 to the dissipative load of the microsensors 13, whose temperatures will rise causing the resistance to change. A low-noise electronic circuit including a column address mux.42 and a row address mux.43 monitors the resistances of the microsensor elements and provides electrical signals 44 to output circuitry dependent on the application such as target detection and recognition.

The microsensor consists of a low-mass sensor element 20 which is almost completely thermally isolated from its supporting structure as shown earlier in Figure 3. A resistance element is fabricated on the sensor using a material whose resistance changes with temperature. Any electrical power dissipated in this sensor resistance (e.g. by direct infrared radiation on the sensor or by mm-wave radiation coupled in from an antenna) heats the sensor element 20 by an amount inversely proportional to the sensor thermal mass and thermal conductance to the supporting structure. The sensitivity of the microsensor requires a low thermal mass sensor and good thermal isolation. The dissipated heat will flow to the supporting structure with a time constant given by the sensor thermal capacity times the thermal resistance to the surroundings. This response time can be arranged to be milliseconds without sacrificing sensitivity; faster response times can be achieved by trading off sensitivity. The thin film resistance element has contacts adapted to be connected to an output circuit. The electrical output signals are obtained by the use of a readout circuit which is sensitive to resistance changes in the microsensor resistance.

The ultimate signal to noise ratio of such a microsensor is achieved by the use of a very small sensor thermal mass, and very high thermal isolation from the supporting structure. The minimum noise level possible is due to Johnson noise in the sensor load resistance, preamplifier noise and to fluctuations in the radiative and conductive power interchanged between the sensor and its surroundings. In the case of mm-wave radiation coupled electrically into a microsensor from a microantenna, the sensor may be coated with a highly reflective material so that radiation interchange noise can be reduced to a low level. In this case the noise limits would be due to a) Johnson noise, b) amplifier noise and c) thermal conduction noise.

Of particular importance is the very low conduction noise which is achieved by the excellent thermal isolation and low mass of the proposed structure. Using typical parameter values demonstrated by the prototype devices, we calculate that noise equivalent power levels of 6x10⁻¹² watts/√Hz are expected, assuming 75% coupling efficiency to the radiative mm-wave field. This calculated figure is in close agreement with experimental data obtained on prototype devices.

### Experimental Results

Prototype devices have been connected to an electronic readout circuit designed to display small resistance changes on an oscilloscope. The sensors were installed in a metal chamber that could be evacuated to vary the sensor thermal leak. Windows of ZnS and glass were available to admit IR and mm-wave radiation into the sensor chamber. A 10 Hz chopper was mounted in front of the sensor window. A 1000°K black body IR source was used to calibrate the sensor with an IR intensity of 7x10⁻⁴ W/CM². A sensor response of about 100 mV was observed with the sensor at atmospheric pressure, and about 400 mV with the sensor cell evacuated. A 3.2 mm (94GHz) CW oscillator source was used to illuminate the sensor with a mm-wave intensity of about 2x10⁻³ w/CM² at the sensor. The observed signal amplitude from the sensor was measured at 280mV. The mm-wave signals increased in amplitude by about a factor of four as the cell pressure was reduced from 10⁵ to 10² Pa. (760 to 0.5 torr) indicating that the signal was due to the normal microsensor thermal response mechanism.

### Microantenna Considerations

The properties of planar antennas lying on dielectric (e.g. Si, Si₃N₄, SiO₂) surfaces are quite different from antennas in homogeneous media. The principal differences are 1) the polar diagram is always heavily biased towards the dielectric, so that efficient collection of radiation is biased towards radiation incident from the dielectric side, and 2) additional peaks in the polar diagram may occur: some peaks are found along the substrate surface plane, indicating coupling to substrate surface waves which will lead to cross-talk between adjacent antennas on that surface. Although the polar diagram of a planar antenna on a dielectric substrate is heavily biased towards the dielectric, this bias can be reversed by depositing a metallic ground plane (e.g.(2000°Å) 0.2 micrometers copper) on the back surface of the silicon substrate as shown in Figure 5a, so that all radiation is reflected towards the air side, and the antenna only "looks" towards the air. This arrangement is very desirable, since IR sensors receive radiation from the airside, and common reflective optics can then be used for an array of mm-wave and IR-sensors fabricated on the same silicon wafer.

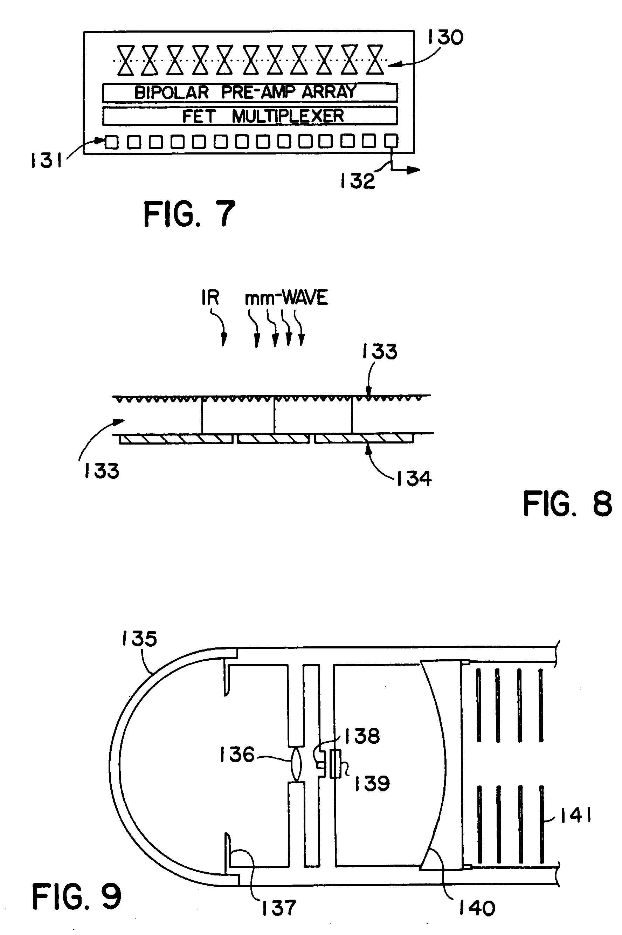

An alternate modification alluded to earlier is the use of "bow-tie" antenna designs where the incident radiation is through the dielectric substrate. Our tests have shown that bow-tie antennas can be used in linear arrays to efficiently collect mm-wave radiation incident through the substrate. In this configuration the IR radiation is absorbed in the front side detector elements while the mm-wave radiation passes through the silicon wafer and is collected by the backside bow-tie antennas (Figure 8). In this approach through-the-wafer interconnects from antenna to sensor are preferably used. This alternate approach offers good performance, with
o Simple, planar geometry fabricated from metal films deposited on Si wafer surfaces.
o A polar diagram heavily biased (by a factor n³), where n is the refractive index, into the dielectric, with beam width tailorable by adjustment of the bow-tie angle as shown in Figure 8.
o A resistive characteristic impedance, tailorable by adjustment of the bow-tie angle, constant over wide frequency range.

### Coupling of Antenna to Microsensors

The simplest way of coupling a dipole antenna to a radiation sensor is to fabricate the sensor between the arms of the dipole and metallize the antenna to the sensor load. The antenna impedance can be matched to sensor loads in the 100 ohm range.

### A High Sensitivity Detector-Material

Referring again to Figure 3 which shows a cross section of a microsensor structure there is shown a detector element 20. The requirements of a high sensitivity material for microbolometer sensor detectors are
a) high thermal coefficient of resistance (TCR)
b) low I/f noise
c) deposited in a thin film of less than 0.1 micrometers (<1000 angstroms)
d) process compatible with microbolometer fabrication technology
e) no anomalous thermal capacity
f) film impedance compatible with microbolometer read-out circuitry (100 to 100,000 ohms).

Vanadium oxides (preferably VO₂) satisfy all these requirements. Vanadium oxides have very strong changes in resistance with temperature, allowing high sensitivity microbolometer operation. The TCR is typically -0.01 to -0.04 per degree Centigrade, and much higher at the semiconductor-to-metal transition. This typical range is much higher than the TCR for the detector material permalloy (previously used) which is approximately 0.0035 per degree Centigrade. The l/f noise can be kept low by the use of high conductivity VO₂, that is, about 1000 ohms/square in (1000 angstrom) 0.1 micrometer films. The VO₂ thin film detector 20 can be deposited directly onto the dielectric layer 21 with a chosen film impedance. This deposition is preferably by the process of ion beam sputter which permits the deposition of very thin layers using growth conditions compatible with the silicon microbridge technology. In the preferred embodiment at this time the VO₂ is operated in its semiconductor phase. An increased thermal capacity occurs at the semiconductor-to-metal phase transition, but is acceptably low.

## Claims

1. A monolithic integrated microbolometer linear array radiation detector for thermal imaging and thermal detection, characterised by:
a semiconductor body (19) having a plurality of depressions (107) formed in a linear pattern on a first surface of the semiconductor body (19);
a plurality of thin film dielectric members (21) each attached to the first surface, at least at one location, and positioned to suspend each dielectric member (21) as a thermally isolated structure over a corresponding depression (107);
a thin film layer of vanadium oxide (20) embedded in each said dielectric member (21) at a location over the corresponding depression (107), said thin film layer having a high temperature coefficient of resistance; and
a contact for each thin film layer of vanadium oxide, adapted to couple to a measuring circuit.

2. A detector according to Claim 1 in which the thin film layer of vanadium oxide is of a thickness ≤ 1 X 10⁻⁷m (1000 angstroms).

3. A detector according to claim 1 or 2 in which the thin film layer of vanadium oxide has a resistivity on the order of 1000 ohms per square.

4. A detector according to any preceding Claim in which the thin film dielectric is of silicon nitride.

5. A detector according to any preceding Claim in which the semiconductor body is of single crystalline silicon.

6. A detector according to any preceding Claim further characterised by one additional integrated microsensor linear array radiation detector positioned on the same semiconductor body (19) as the first integrated microsensor linear array radiation detector to form a two-dimensional array.

7. A detector according to Claim 6 wherein the monolithic integrated microsensor linear arrays are located at the focal plane of a thermal imaging system.

8. A detector according to any preceding Claim wherrein a subset of the plurality of thin film layers of vanadium oxide are each coupled to an antenna member.

9. A detector according to Claim 8 wherein the antenna member comprises a metal film conductor having dimensions on the order of the wavelength.

10. A detector according to Claim 9 further characterised by a metallic ground plane disposed on a second surface of the semiconductor body opposite the first surface of the semiconductor body.

## Patentansprüche

1. Der thermischen Bildaufnahme oder thermischen Detektion dienender Strahlungsdetektor in Form einer linearen, monolithisch integrierten Mikrobolometeranordnung, **gekennzeichnet durch:**
einen Halbleiterkörper (19) mit mehreren, in einem linearen Muster in einer ersten Oberfläche des Halbleiterkörpers angeordneten Vertiefungen (107);
mehreren dielektrischen Dünnschichtelementen (21), welche jeweils wenigstens an einer Stelle an der ersten Oberfläche derart befestigt sind, daß jedes Dünnschichtelement (21) als thermisch isolierte Struktur über einer entsprechenden Vertiefung liegt;
eine in jedes Dünnschichtelement (21) an einer Stelle über der entsprechenden Vertiefung (107) eingebettete Dünnfilmschicht (20) aus Vanadiumoxyd, welche einen hohen thermischen Widerstandskoeffizienten hat; und
einen an eine Meßschaltung anschließbaren Kontakt für jede Vanadiumoxyd-Dünnschicht.

2. Detektor nach Anspruch 1, bei dem die Dünnschicht aus Vanadiumoxyd eine Dicke von ≤1 x 10⁻⁷ m (1000 Å) hat.

3. Detektor nach Anspruch 1 oder 2, bei dem die Dünnschicht aus Vanadiumoxyd einen spezifischen Widerstand in der Größenordnung von 1000 Ohm⁻² hat.

4. Detektor nach einem vorangehenden Anspruch, bei dem die dielektrische Dünnschicht aus Siliziumnitrid besteht.

5. Detektor nach einem vorangehenden Anspruch, bei dem der Halbleiter aus einkristallinem Silizium besteht.

6. Detektor nach einem vorangehenden Anspruch, ferner **gekennzeichnet durch** einen zusätzlichen, als lineare Mikrosensoranordnung ausgebildeten Strahlungsdetektor auf dem gleichen Halbleiterkörper (19) wie der erste, als integrierte lineare Mikrosensoranordnung ausgebildete Strahlungsdetektor, so daß eine zweidimensionale Anordnung entsteht.

7. Detektor nach Anspruch 6, bei dem die monolithisch integrierten linearen Mikrosensoranordnungen in der Brennebene eines thermischen Abbildungssystems angeordnet sind.

8. Detektor nach einem vorangehenden Anspruch, bei dem eine Untergruppe der Vielzahl von Dünnfilmschichten aus Vanadiumoxyd jeweils an ein Antennenelement angeschlossen ist.

9. Detektor nach Anspruch 8, bei dem das Antennenelement einen Metallfilmleiter mit Abmessungen in der Größenordnung der Wellenlänge aufweist.

10. Detektor nach Anspruch 9, ferner **gekennzeichnet durch** eine metallische Bodenplatte auf einer der ersten Oberfläche des Halbleiterkörpers gegenüberliegenden zweiten Oberfläche.

## Revendications

1. Détecteur de rayonnement monolithique à réseau linéaire de microbolomètres intégrés destiné à l'imagerie thermique et la détection thermique, caractérisé par:
- un corps semi-conducteur (19) ayant une pluralité de dépressions (107) formé selon un motif linéaire sur une première surface du corps semi-conducteur (19) ;
- une pluralité d'éléments de film mince diélectrique (21) chacun fixé à la première surface, au moins à un emplacement, et positionné de façon à suspendre chaque élément diélectrique (21) en tant que structure thermiquement isolée au-dessus d'une dépression correspondante (107);
- une couche de film mince d'oxyde de vanadium (20) incorporée dans chacun desdits éléments diélectriques (21) à un emplacement au-dessus de la dépression correspondante (107), ladite couche de film mince ayant un coefficient élevé de résistance en température; et
- un contact pour chaque couche de film mince d'oxyde de vanadium, adapté pour la coupler à un circuit de mesure.

2. Détecteur selon la revendication 1, dans lequel la couche de film mince d'oxyde de vanadium est d'une épaisseur inférieure ou égale à 1 x 10⁻⁷ m (1 000 angstroems).

3. Détecteur selon la revendication 1 ou 2, dans lequel la couche de film mince d'oxyde de vanadium possède une résistivité de l'ordre de 1 000 ohm carré.

4. Détecteur selon l'une quelconque des revendications précédentes, dans lequel le film mince diélectrique est du nitrure de silicium.

5. Détecteur selon l'une quelconque des revendications précédentes, dans lequel le corps semi-conducteur est un monocristal de silicium.

6. Détecteur selon l'une quelconque des revendications précédentes, caractérisé de plus par un détecteur de rayonnement supplémentaire à réseau linéaire de microdétecteurs intégrés positionné sur le même corps semi-conducteur (19) en tant que premier détecteur de rayonnement à réseau linéaire de microdétecteurs intégrés pour former un réseau bidimensionnel.

7. Détecteur selon la revendication 6, dans lequel les réseaux linéaires de microdétecteurs intégrés monolithiques sont situés au plan focal d'un système d'imagerie thermique.

8. Détecteur selon l'une quelconque des revendications précédentes, dans lequel un sous-ensemble de la pluralité des couches de film mince d'oxyde de vanadium est chacun couplé à un élément d'antenne.

9. Détecteur selon la revendication 8, dans lequel l'élément d'antenne comprend un conducteur de film métallique ayant des dimensions de l'ordre de la longueur d'onde.

10. Détecteur selon la revendication 9, caractérisé de plus par un plan de masse métallique disposé sur une deuxième surface du corps semi-conducteur opposée à la première surface du corps semi-conducteur.
